Europäisches Patentamt

European Patent Office

Office européen des brevets

(19)

(11) **EP 0 707 216 A2**

(12) **DEMANDE DE BREVET EUROPEEN**

(43) Date de publication:
17.04.1996 Bulletin 1996/16

(51) Int Cl.6: **G01R 19/25**

(21) Numéro de dépôt: 95402282.8

(22) Date de dépôt: 13.10.1995

(84) Etats contractants désignés:
**ES FR GB IT NL**

(30) Priorité: 13.10.1994 DE 4436593

(71) Demandeur: GENERAL ELECTRONIK GMbH bei
MAGDEBURG
D-39167 Hohendodeleben bei Magdeburg (DE)

(72) Inventeurs:
• Szoboszlai, Istvan
F-74290 Veyrier du Lac (FR)
• Rapp, Lothar
D-90556 Cadolzburg (DE)

(74) Mandataire: Kohn, Philippe
3, Sente des Dorées
F-75019 Paris (FR)

(54) **Procédé et pince ampèremétrique pour la détermination de la capacité de compensation destinée à un réseau électrique**

(57)    L'invention concerne un procédé caractérisé en ce que, en temps réel et avec un échantillonnage rapide, on numérise les grandeurs de mesure pour le courant et la tension, on détermine et on mémorise de manière temporaire la période (T) des signaux, la consommation active (Wa) et la consommation réactive (Wr) pendant un laps de temps prédéterminé (N.ts) ainsi que la somme des carrés de la tension ($\Sigma U^2$) pendant le même laps de temps, on entre une valeur de consigne ($\phi c$) pour le déphasage angulaire ($\phi$) subsistant lors de l'introduction de la capacité de compensation dans le réseau électrique et on détermine, à partir des valeurs mémorisées de manière temporaire (T, Wa, Wr, $\Sigma U^2$) et de la valeur de consigne ($\phi c$) la capacité de compensation (Cc) selon la formule suivante :

$$Cc = k \cdot \frac{(Wa - Wr) \cdot tg\varphi c}{\sum\limits_{0}^{N-1} U_n^2} \cdot \frac{T}{ts}$$

dans laquelle k est une constante de normalisation, ts est l'intervalle de temps séparant deux valeurs d'échantillonnage lors de la numérisation et N est le nombre des valeurs d'échantillonnage obtenues dans ledit laps de temps déterminé, N.ts.

Fig. 1

## Description

La présente invention concerne un procédé pour la détermination de la valeur d'une capacité de compensation destinée à un réseau électrique.

Les réseaux électriques à moyenne et haute tension, en particulier ceux se trouvant à l'intérieur d'une entreprise, sont, dans la plupart des cas, à charge inductive si bien qu'il y a la nécessité de compenser, de manière localisée ou centralisée, le déphasage entre le courant et la tension qui en résulte au moyen de capacités de compensation correspondantes.

Le but théorique de la compensation est d'obtenir un déphasage nul, mais, dans la pratique, ceci est rarement atteint car les conditions de charge à l'intérieur d'une entreprise varient en permanence. En outre, on ne dispose que de condensateurs dont les valeurs des capacités ne peuvent être choisies que dans une série de valeurs normalisées et il n'est pas possible de prendre une combinaison de ces valeurs normalisées pour obtenir une capacité donnant un déphasage nul pour des raisons de coût et d'encombrement.

Cela conduit dans la pratique à déterminer, à partir d'un déphasage non compensé mesuré, une capacité de compensation de consigne qui est introduite dans le réseau électrique et, à partir d'une nouvelle mesure basée sur le déphasage subsistant, on introduit la valeur normalisée la plus proche dans le réseau électrique.

Le problème à la base de l'invention est de fournir un procédé le plus simple possible, et un dispositif, pour la détermination de la capacité de compensation nécessaire pour un réseau électrique en prenant en compte le déphasage résiduel.

A cet effet, la présente invention a pour objet un procédé pour la détermination de la valeur d'une capacité de compensation, Cc, destinée à un réseau électrique, caractérisé en ce que, en temps réel et avec un échantillonnage rapide, on numérise les grandeurs de mesure pour le courant et la tension, on détermine et on mémorise de manière temporaire la période, T, des signaux, la consommation active, Wa, et la consommation réactive, Wr, pendant un laps de temps prédéterminé, N.ts, ainsi que la somme des carrés de la tension, $\Sigma U^2$, pendant le même laps de temps, on entre une valeur de consigne, $\varphi c$, pour le déphasage angulaire, $\varphi$, subsistant lors de l'introduction de la capacité de compensation dans le réseau électrique et on détermine, à partir des valeurs mémorisées de manière temporaire, T, Wa, Wr, $\Sigma U^2$, et de la valeur de consigne, $\varphi c$, la capacité de compensation, Cc, selon la formule suivante:

$$Cc = k \cdot \frac{(Wa - Wr) \cdot tg\varphi c}{\sum_{0}^{N-1} U_n^2} \cdot \frac{T}{ts}$$

dans laquelle k est une constante de normalisation, ts est l'intervalle de temps séparant deux valeurs d'échantillonnage lors de la numérisation et N est le nombre des valeurs d'échantillonnage obtenues dans ledit laps de temps déterminé, N . ts.

En particulier, la valeur de consigne, $\varphi c$, entrée pour le déphasage résiduel, $\varphi$, permet à l'utilisateur de trouver plus facilement la capacité de compensation qui convient car cela permet, par exemple, d'entrer successivement une valeur de consigne, $\varphi c$, nulle ainsi qu'une valeur de consigne, $\varphi c$, qui diffère de cette valeur nulle et qui correspond au déphasage résiduel, $\varphi$, maximal permis ou prévu et de trouver une combinaison de condensateurs de valeurs normalisées se trouvant entre les deux capacités de compensation qui ont été déterminées à partir de ces valeurs de consigne, $\varphi c$.

Il est particulièrement avantageux de mettre en oeuvre ce procédé dans un appareil à pince (pince ampèremétrique), dans lequel on mesure le courant en fermant la pince de mesure sur le conducteur sur lequel on doit faire la mesure et on mesure la tension en reliant des entrées additionnelles de mesure de tension aux conducteurs sur lesquels on doit faire la mesure, la numérisation des valeurs de mesure est réalisée au moyen d'au moins un convertisseur analogique-numérique, on détermine, à partir des valeurs d'échantillonnage numérisées, la période, T, des signaux, la consommation active, Wa, et la consommation réactive, Wr, pendant un laps de temps prédéterminé, N.ts, ainsi que la somme des carrés de la tension, $\Sigma U^2$, pendant le même laps de temps, ces valeurs sont mémorisées de manière temporaire dans une mémoire tampon, on entre, au moyen d'éléments de commande de l'appareil à pince, une valeur de consigne, $\varphi c$, pour le déphasage angulaire, $\varphi$, subsistant lors de l'introduction de la capacité de compensation, Cc, dans le réseau électrique et on détermine, à partir des valeurs mémorisées de manière temporaire, T, Wa, Wr, $\Sigma U^2$, et de la valeur de consigne, $\varphi c$, la capacité de compensation, Cc, selon la formule suivante:

$$Cc = k \cdot \frac{(Wa - Wr) \cdot tg\varphi c}{\sum_{0}^{N-1} U_n^2} \cdot \frac{T}{ts}$$

dans laquelle k est une constante de normalisation, ts est l'intervalle de temps séparant deux valeurs d'échantillonnage lors de la numérisation et N est le nombre des valeurs d'échantillonnage obtenues dans ledit laps de temps déterminé, N . ts, et on affiche la valeur de la capacité de compensation, Cc au moyen d'un afficheur de l'appareil à pince (pince ampèremétrique).

D'autres caractéristiques et avantages de l'invention ressortiront de la description qui suit, faite à titre illustratif et nullement limitatif, en se référant aux dessins annexés dans lesquels :

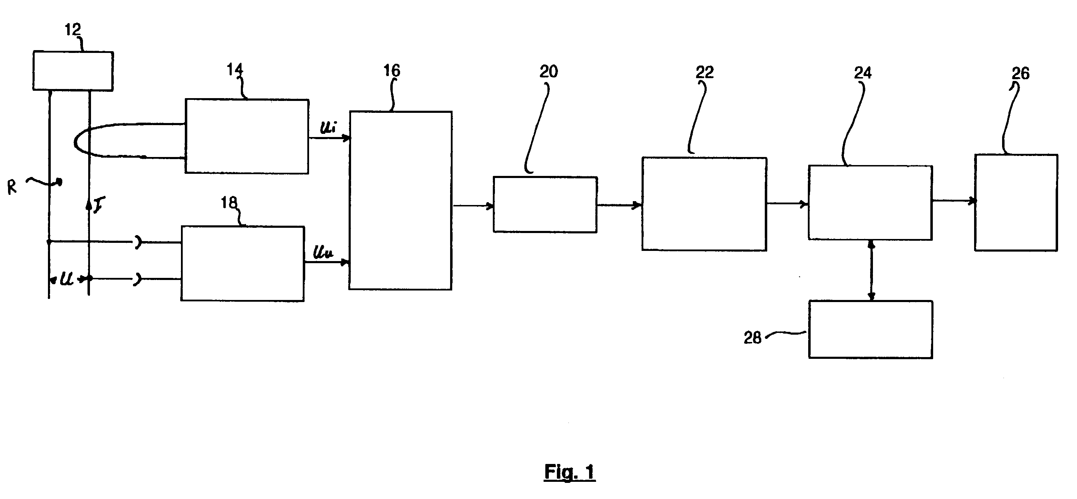

- la figure 1 est un schéma synoptique du traitement des signaux d'un appareil à pince (pince ampèremétrique), et
- la figure 2 est un diagramme de fonctionnement pour la détermination de la capacité de compensation.

Pour la mesure des grandeurs électriques d'un réseau électrique R comportant une charge 12 qui est composée de charges résistives et de charges inductives, un conducteur est enfermé dans la pince de mesure de l'appareil à pince. Au moyen d'une entrée de courant 14 qui amplifie le signal en tension fourni par l'élément à effet Hall de la pince de mesure, une tension de mesure Ui proportionnelle au courant mesuré parvient à une première entrée d'un multiplexeur 16. Une deuxième entrée du multiplexeur 16 est reliée à la sortie d'une borne d'entrée de tension 18 dont l'entrée est, à son tour, reliée aux deux conducteurs du réseau électrique R et qui fournit une deuxième tension de mesure Uu proportionnelle à la tension mesurée.

La sortie du multiplexeur 16 est reliée à l'entrée d'un convertisseur analogique-numérique 20 qui, à des intervalles de temps fixes prédéterminés, de manière synchrone avec le multiplexeur 16, transforme la valeur instantanée de chacune des valeurs de la tension Ui, respectivement Uu, en une valeur numérique et transmet cette valeur numérique à un processeur numérique de signaux 22.

Dans ce processeur numérique de signaux 22, qui est particulièrement adapté au traitement rapide des signaux et peut donc exécuter plusieurs étapes de calcul entre des valeurs numériques successives de Ui et de Uu, en prenant en compte la linéarisation et la correction de zéro connues d'après le document EP-A-0.263.154, on forme les sommations cycliques suivantes de n = 0 à N-1 afin de déterminer les grandeurs électriques:

$$\Sigma U_n; \ \Sigma I_n; \ \Sigma |U_n|; \ \Sigma |I_n|; \ \Sigma U_n^2; \ \Sigma I_n^2; \ \Sigma(U_n \cdot I_n)$$

Ces valeurs de sommations représentent des résultats intermédiaires destinés à la détermination, qui est réalisée ensuite, de la consommation active, Wa, et de la consommation réactive, Wr, selon des procédés de calcul connus qui sont exécutés en temps réel par le processeur numérique de signaux 22. Les valeurs de sommation sont envoyées de manière cyclique, par exemple toutes les 0,5 seconde à un microprocesseur 24 qui calcule la consommation active, Wa, et la consommation réactive, Wr, à partir de ces valeurs de sommation. Ce calcul n'est pas aussi critique que le calcul des valeurs de sommation et peut donc être effectué par un microprocesseur usuel qui peut, en outre, prendre en charge des tâches supplémentaires telles que la commande d'un afficheur 26 et l'interrogation d'éléments de commande, tels que la commande du système de l'appareil à pince.

Les valeurs fournies par le microprocesseur 24 pour la consommation active, Wa, et la consommation réactive, Wr, et la période, T, déterminée par les passages à zéro des signaux ainsi que la somme $\Sigma U_n^2$ sont mémorisées dans une mémoire tampon 28.

A partir des valeurs mémorisées et en utilisant la formule suivante:

$$Cc = k \cdot \frac{(Wa - Wr) \cdot tg\varphi c}{\sum\limits_{0}^{N-1} U_n^2} \cdot \frac{T}{ts}$$

on calcule la capacité de compensation Cc et on l'affiche sur l'afficheur 26.

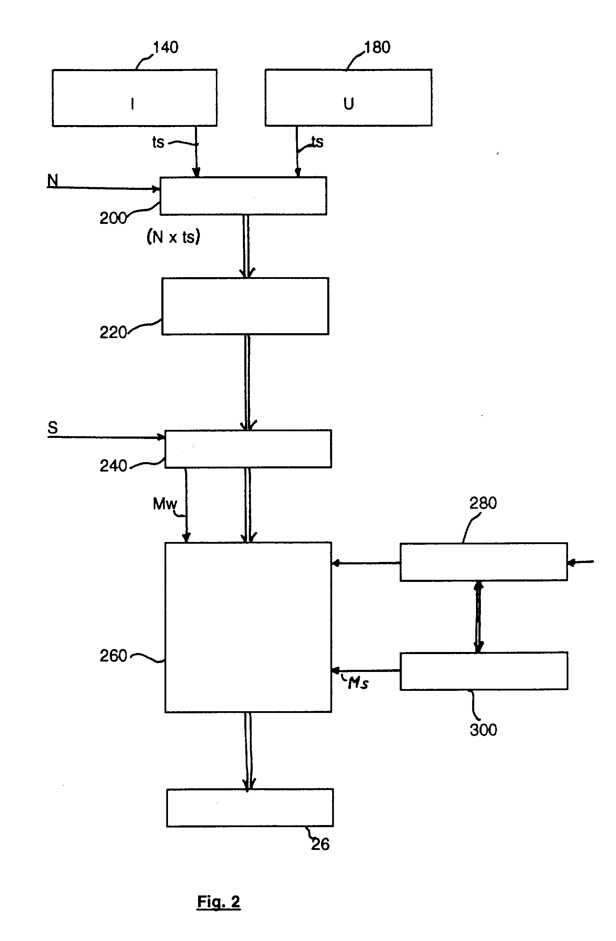

La figure 2 est un diagramme de fonctionnement pour une telle détermination de la capacité de compensation, Cc.

A des intervalles de temps égaux à ts, une borne d'entrée 140 fournit des valeurs d'échantillonnage numérisées du courant mesuré, I, et une deuxième borne d'entrée 180 fournit des valeurs d'échantillonnage numérisées de la tension mesurée, U. Ces valeurs sont envoyées à une étape de formation de sommes 200 qui élabore les sommes indiquées plus haut de manière cyclique, à chaque fois pour un nombre N, transmis par une autre entrée, de valeurs d'échantillonnage.

Les sommes ainsi obtenues sont utilisées de manière cyclique (N.ts) pour le calcul de la consommation active, Wa, et de la consommation réactive, Wr,. De plus, la période, T, est déterminée à partir des passages à zéro des signaux.

En fonction du mode fixé pour le procédé, ces valeurs sont enregistrées, également de manière cyclique, dans une mémoire tampon ou reçues dans la mémoire tampon 240 sous la commande d'un signal appliqué à une entrée de commande S.

Le calcul de la capacité de compensation, Cc, s'effectue dans le bloc 260 en utilisant les valeurs mémorisées dans la mémoire tampon 240 et la valeur de déphasage mémorisée dans une mémoire 280 de valeur de consigne, φc,. La valeur inscrite dans cette mémoire 280 de valeur de consigne est surveillée en ce qui concerne ses variations par un comparateur 300 et elle peut être soit chargée directement avec des valeurs numériques au moyen d'éléments de commande de la pince de mesure (non représentés), soit le contenu peut être modifié constamment au moyen d'un signal de compteur-décompteur avec une logique correspondante.

Un nouveau calcul est déclenché soit par une modification de la valeur de consigne, φc, détectée par le comparateur 300 et qui est signalée par le signal Ms au bloc 260, soit par de nouvelles mesures parvenues dans la mémoire tampon et qui sont signalées par le signal Mw au bloc 260.

En fonction des dimensions et de la structure de l'afficheur 26 utilisé, on peut représenter la valeur de consigne, φc, et la capacité de compensation, Cc, simultanément ou au choix.

Dans un exemple de réalisation, la période d'échantillonnage, ts, peut être ajustée entre 61 microsecondes et 15,6 millisecondes (pour un couple d'échantillons courant/tension) et le nombre d'échantillons, N, peut être ajusté de 1 à 8192 selon la fréquence des signaux mesurés.

## Revendications

1. Procédé pour la détermination de la valeur d'une capacité de compensation (Cc) destinée à un réseau électrique, caractérisé en ce que, en temps réel et avec un échantillonnage rapide, on numérise les grandeurs de mesure pour le courant et la tension, on détermine et on mémorise de manière temporaire la période (T) des signaux, la consommation active (Wa) et la consommation réactive (Wr) pendant un laps de temps prédéterminé (N.ts) ainsi que la somme des carrés de la tension ($\Sigma U^2$) pendant le même laps de temps, on entre une valeur de consigne ($\varphi c$) pour le déphasage angulaire ($\varphi$) subsistant lors de l'introduction de la capacité de compensation dans le réseau électrique et on détermine, à partir des valeurs mémorisées de manière temporaire (T, Wa, Wr, $\Sigma U^2$) et de la valeur de consigne ($\varphi c$) la capacité de compensation (Cc) selon la formule suivante:

$$Cc = k \cdot \frac{(Wa - Wr) \cdot tg\varphi c}{\sum_{0}^{N-1} U_n^2} \cdot \frac{T}{ts}$$

dans laquelle k est une constante de normalisation, ts est l'intervalle de temps séparant deux valeurs d'échantillonnage lors de la numérisation et N est le nombre des valeurs d'échantillonnage obtenues dans ledit laps de temps déterminé, N.ts.

2. Procédé selon la revendication 1, caractérisé en ce que l'on refait la détermination de la capacité de compensation (Cc) lorsque la valeur de consigne entrée ($\varphi c$) varie.

3. Procédé selon la revendication 1 ou 2, caractérisé en ce que les valeurs mémorisées de manière temporaire (T, Wa, Wr, $\Sigma U^2$) sont mémorisées sans modification jusqu'à ce qu'un nouveau cycle de mesure soit initié du fait d'un signal d'entrée (S).

4. Procédé selon la revendication 1 ou 2, caractérisé en ce que les valeurs mémorisées de manière temporaire (T, Wa, Wr, $\Sigma U^2$) sont, à chaque fois, après le déroulement du laps de temps déterminé (N . ts) remplacées par les nouvelles valeurs déterminées et qu'ensuite on refait la détermination de capacité de compensation (Cc).

5. Procédé selon l'une quelconque des revendications précédentes, caractérisé en ce que l'on détermine une capacité de compensation (Cc) pour une valeur de consigne ($\varphi c$) nulle ainsi que pour une valeur de consigne entrée ($\varphi c$) qui diffère de cette valeur.

6. Appareil à pince (pince ampèremétrique), dans lequel on mesure le courant en fermant la pince de mesure sur le conducteur sur lequel on doit faire la mesure et on mesure la tension en reliant des entrées additionnelles de mesure de tension aux conducteurs sur lesquels on doit faire la mesure, caractérisé en ce que la numérisation des valeurs de mesure est réalisée au moyen d'au moins un convertisseur analogique-numérique (20) on détermine, à partir des valeurs d'échantillonnage numérisées, la période (T) des signaux, la consommation active (Wa) et la consommation réactive (Wr) pendant un laps de temps prédéterminé (N·ts) ainsi que la somme des carrés de la tension ($\Sigma U^2$) pendant le même laps de temps, ces valeurs sont mémorisées de manière temporaire dans une mémoire tampon (28), on entre, au moyen d'éléments de commande de l'appareil à pince, une valeur de consigne, $\varphi c$, pour le déphasage angulaire ($\varphi$) subsistant lors de l'introduction de la capacité de compensation (Cc) dans le réseau électrique et on détermine, à partir des valeurs mémorisées de manière temporaire (T, Wa, Wr, $\Sigma U^2$) et de la valeur de consigne ($\varphi c$), la capacité de compensation (Cc) selon la formule suivante:

$$Cc = k \cdot \frac{(Wa - Wr) \cdot tg\varphi c}{\sum_{0}^{N-1} U_n^2} \cdot \frac{T}{ts}$$

dans laquelle k est une constante de normalisation, ts est l'intervalle de temps séparant deux valeurs d'échantillonnage lors de la numérisation et N est le nombre des valeurs d'échantillonnage obtenues dans ledit laps de temps déterminé, N . ts, et on affiche la valeur de la capacité de compensation (Cc) au moyen d'un afficheur (26) de l'appareil à pince (pince ampèremétrique).

7. Appareil à pince selon la revendication 6, caractérisé en ce que la détermination de capacité de compensation (Cc) est répétée lorsqu'un circuit logique de surveillance détecte qu'il y a une valeur modifiée de la valeur de consigne entrée ($\varphi c$).

8. Appareil à pince selon la revendication 6 ou 7, caractérisé en ce que l'on prévoit un signal d'entrée (S) qui initie un nouveau cycle de mesure.

9. Appareil à pince selon la revendication 6, caractérisé en ce que les valeurs mémorisées de manière temporaire (T, Wa, Wr, $\Sigma U^2$) sont, à chaque fois, après le déroulement du laps de temps déterminé (N . ts) remplacées par les nouvelles valeurs déterminées et qu'ensuite on refait la détermination de capacité de compensation (Cc).

10. Appareil à pince selon l'une quelconque des revendications 6 à 9, caractérisé en ce que l'on détermine une capacité de compensation (Cc) pour une valeur de consigne, $\varphi c$, nulle ainsi que pour une valeur de consigne entrée ($\varphi c$) qui diffère de cette valeur et en ce que ces deus valeurs de la capacité de compensation (Cc).sont affichées simultanément sur un afficheur comportant au moins deux lignes.

11. Appareil à pince selon l'une quelconque des revendications 6 à 10, caractérisé en ce que la valeur de consigne actuelle ($\varphi c$) et la capacité de compensation (Cc) qui a été déterminée sont affichées en même temps sur un afficheur comportant au moins deux lignes.

**Fig. 1**

**Fig. 2**